(19) Europäisches Patentamt
European Patent Office
Office européen des brevets

(11) EP 3 688 475 B1

(12) FASCICULE DE BREVET EUROPEEN

(45) Date de publication et mention de la délivrance du brevet:
**13.09.2023 Bulletin 2023/37**

(21) Numéro de dépôt: **18770061.2**

(22) Date de dépôt: **25.09.2018**

(51) Classification Internationale des Brevets (IPC):
***G01R 29/08*** *(2006.01)*

(52) Classification Coopérative des Brevets (CPC):
**G01R 29/0885; G01R 33/0052; G01R 33/1284;**
G01R 29/12; G01R 33/02

(86) Numéro de dépôt international:
**PCT/EP2018/076028**

(87) Numéro de publication internationale:
**WO 2019/063572 (04.04.2019 Gazette 2019/14)**

(54) **COMPOSANT SENSIBLE POUR DISPOSITIF DE MESURE DE CHAMP ELECTROMAGNETIQUE PAR THERMOFLUORESCENCE, PROCEDES DE MESURE ET DE FABRICATION CORRESPONDANTS**

EMPFINDLICHES BAUTEIL FÜR EINE VORRICHTUNG ZUR MESSUNG EINES ELEKTROMAGNETISCHEN FELDES DURCH THERMOFLUORESZENZ, ENTSPRECHENDE MESS- UND HERSTELLUNGSVERFAHREN

SENSITIVE COMPONENT FOR DEVICE FOR MEASURING ELECTROMAGNETIC FIELD BY THERMOFLUORESCENCE, CORRESPONDING MEASUREMENT AND MANUFACTURING METHODS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.09.2017 FR 1758907**

(43) Date de publication de la demande:
**05.08.2020 Bulletin 2020/32**

(73) Titulaire: **Office National d'Etudes et de Recherches Aérospatiales
91123 Palaiseau Cedex (FR)**

(72) Inventeurs:
• **BOBO, Jean-François
31550 Gaillac-Toulza (FR)**
• **CARREY, Julian
31400 Toulouse (FR)**
• **FAURE, Stéphane
31140 Launaguet (FR)**
• **ISAAC, François
31290 Villenouvelle (FR)**
• **PROST, Daniel
31000 Toulouse (FR)**

(74) Mandataire: **Vidon Brevets & Stratégie
16B, rue de Jouanet
BP 90333
35703 Rennes Cedex 7 (FR)**

(56) Documents cités:
**WO-A1-90/08952      US-A- 3 693 084
US-A- 5 110 216      US-A- 5 658 673**

**Description**

## 1. DOMAINE DE L'INVENTION

L'invention concerne la mesure du champ électromagnétique.

Plus précisément, l'invention concerne une conception nouvelle du composant sensible d'un dispositif de mesure de champ électromagnétique, plus couramment appelé capteur de champ électromagnétique.

L'invention a de nombreuses applications, telles que par exemple la caractérisation du champ électrique et/ou magnétique de systèmes rayonnants tels que les radiotéléphones, les antennes, les émetteurs-récepteurs hyperfréquences, les dispositifs à micro-ondes, les lignes à haute-tension, les circuits imprimés, les dispositifs radars, les dispositifs à induction, etc.

## 2. ARRIÈRE-PLAN TECHNOLOGIQUE

Les capteurs de champ électromagnétique de l'état de la technique, à partir desquels la présente technologie a été développée, comprennent un composant sensible à l'énergie produite par un champ électromagnétique, dont les propriétés thermiques sont exploitées pour mesurer le champ électromagnétique. Ce composant sensible comprend une couche mince d'un matériau absorbant, apte à absorber partiellement l'énergie du champ électromagnétique que l'on souhaite mesurer et à convertir cette énergie en chaleur. L'échauffement du matériau absorbant se traduit par l'émission d'une lumière infrarouge qui est détectée par une caméra infrarouge équipant le capteur. La lumière infrarouge détectée, convertie par exemple sous la forme d'une image thermique, permet de caractériser le champ électromagnétique dans lequel se trouve le composant sensible. Cette technique connue, dite thermographie infrarouge, est plus amplement décrite dans le document de brevet FR2787583. Elle permet d'obtenir une cartographie bidimensionnelle ou tridimensionnelle du champ électromagnétique par analyse du rayonnement infrarouge produit par le composant sensible (technique aussi connue sous le nom de EMIR®).

Toutefois, l'usage d'un détecteur infrarouge rend la mise en oeuvre du capteur électromagnétique relativement coûteuse.

De plus, cette technique requiert nécessairement la présence d'un support électromagnétiquement et thermiquement neutre pour supporter la couche de matériau absorbant. Une telle configuration n'est pas toujours adaptée à la mesure de champ électromagnétique de certains objets (objets produisant un champ électromagnétique de forme complexe ou mal connue par exemple).

Il est connu par ailleurs d'associer au matériau absorbant avec un matériau fluorescent capable de réémettre une lumière fluorescente dont l'intensité lumineuse dépend de la température du composant, comme décrit dans le document de brevet US 5 658 673. Toutefois, une telle approche ne permet pas de déterminer de façon précise de la température du composant.

## 3. OBJECTIFS DE L'INVENTION

L'invention, dans au moins un mode de réalisation, a notamment pour objectif de pallier ces différents inconvénients de l'état de la technique.

Plus précisément, dans au moins un mode de réalisation de l'invention, un objectif est de fournir un capteur de champ électromagnétique à coût réduit.

Au moins un mode de réalisation de l'invention a également pour objectif de fournir une technique de fabrication d'un capteur de champ électromagnétique qui soit simple à mettre en oeuvre et peu coûteuse.

Un autre objectif d'au moins un mode de réalisation de l'invention est de fournir une technique de mesure de champ électromagnétique à large bande spectrale.

Un autre objectif d'au moins un mode de réalisation de l'invention est de fournir une technique de mesure de champ électromagnétique s'adaptant à tout type de structures ou d'objets.

Un objectif complémentaire d'au moins un mode de réalisation de l'invention est de fournir une technique de visualisation bidimensionnelle ou tridimensionnelle du champ électromagnétique qui soit simple et peu coûteuse à mettre en oeuvre.

## 4. EXPOSÉ DE L'INVENTION

Dans un mode de réalisation particulier de l'invention, il est proposé un composant sensible à un champ électromagnétique tel que défini dans la revendication indépendante 1.

L'invention repose sur une approche astucieuse consistant à tirer profit des propriétés de thermofluorescence d'un matériau fluorescent et thermosensible pour réaliser des mesures de champ électromagnétique. L'invention consiste à utiliser l'échauffement du premier matériau absorbant partiellement l'énergie du champ électromagnétique et l'associer à un deuxième matériau fluorescent qui est sensible à la température pour permettre la caractérisation du champ électromagnétique. Ce deuxième matériau est en effet apte, lorsque soumis à une lumière d'excitation prédéterminée, à réémettre une lumière par fluorescence dont l'intensité lumineuse dépend de la température du premier matériau.

On entend par « matériau absorbant », un matériau absorbant partiellement l'énergie du champ électromagnétique, c'est-à-dire absorbant entre 1% et 20% de l'énergie du champ électromagnétique. On entend par « placé en contact » le fait que le deuxième matériau est disposé par rapport au premier matériau de façon à ce qu'un transfert thermique s'opère du premier vers le deuxième matériau. Enfin, on entend par « champ électromagnétique », le fait que le composant sensible est sensible à un champ électrique et/ou un champ magnétique.

Selon une première mise en oeuvre particulière de l'invention, le composant sensible se présente sous la forme d'une structure en couches superposées comprenant une première couche dudit premier matériau et une deuxième couche dudit deuxième matériau s'étendant sur ladite première couche.

Cette configuration particulière est simple et peu coûteuse à mettre en oeuvre. A noter que chaque couche de premier ou de deuxième matériau est formée d'au moins une couche mince de ce matériau.

Selon une deuxième mise en oeuvre particulière de l'invention, le composant sensible se présente sous la forme d'une couche au sein de laquelle lesdits premier et deuxième matériaux sont mélangés de manière homogène.

Cette configuration particulière permet une diffusion efficace de l'énergie thermique du premier matériau au deuxième matériau. Les mesures de température sont donc plus représentatives de la température du premier matériau, rendant les mesures de champ électromagnétique de fait plus précises.

Selon une réalisation particulière du composant, ledit premier matériau est un matériau composite comprenant une matrice électriquement isolante et des particules électriquement conductrices. Cette réalisation particulière est particulièrement bien adaptée à la mesure du champ électrique.

Selon une variante de réalisation, le premier matériau est un matériau composite comprenant une matrice électriquement isolante et des particules magnétiques. Cette variante de réalisation est particulièrement bien adaptée à la mesure du champ magnétique.

Selon un aspect particulier de l'invention, la première couche est configurée sous forme d'un réseau périodique de plots dudit premier matériau, ledit premier matériau étant un matériau magnétique ou ferromagnétique. Cette configuration particulière permet d'améliorer la sensibilité des mesures de champ magnétique.

Selon un aspect particulier de l'invention, ledit deuxième matériau comprend au moins un composé appartenant à la famille des fluorophores.

Selon un aspect particulier de l'invention, ledit deuxième matériau est thermosensible dans une plage de températures comprise entre -200 et + 300 degrés Celsius. Cette plage correspond aux conditions de température dans l'espace.

Selon un autre aspect de l'invention, ledit deuxième matériau est thermosensible dans une plage de températures comprise entre 10 et 40 degrés Celsius. Cette plage correspond aux conditions de température dite ambiante. Les mesures de champ électromagnétique peuvent ainsi être effectuées à température ambiante.

Selon une caractéristique particulière de l'invention, la lumière d'excitation prédéterminée et la lumière par fluorescence réémise présentent une longueur d'onde différente. On évite ainsi de faire chevaucher le spectre d'excitation du matériau fluorescent avec son spectre d'émission de fluorescence. De façon privilégiée, on choisira le matériau fluorescent de sorte que la longueur d'onde de la lumière d'excitation et la longueur d'onde de la lumière par fluorescence sont les plus éloignées l'une de l'autre, afin de faciliter l'exploitation des mesures.

Selon une caractéristique particulière de l'invention, la longueur d'onde de la lumière d'excitation prédéterminée est comprise dans la plage 300 à 500 nm et en ce que la longueur d'onde de la lumière par fluorescence a une longueur d'onde comprise dans la plage 400 à 800 nm. Cela offre la possibilité d'utiliser un détecteur conçu pour détecter la lumière dans la bande spectrale du visible, ce qui évite l'utilisation d'un détecteur infrarouge traditionnel qui est relativement coûteux.

Selon l'invention, ledit deuxième matériau comprend une pluralité de composés fluorescents chacun apte à réémettre une lumière par fluorescence de longueur d'onde distincte. Cela permet d'obtenir des mesures de champ électromagnétique plus précises en déterminant la température du composant à partir de valeurs relatives d'intensité lumineuse et non de valeurs absolues. Ainsi, la lumière par fluorescence réémise par le composant sensible est composée d'autant de longueurs d'onde que de composés fluorescents différents présents dans le deuxième matériau, ce qui permet d'améliorer la fiabilité des mesures de champ électromagnétique.

Dans un autre mode de réalisation particulier de l'invention, il est proposé un dispositif de mesure d'un champ électromagnétique, comprenant un composant sensible tel que défini précédemment dans l'un quelconque de ses différents modes de réalisation, ledit dispositif comprenant en outre : une source de lumière d'excitation configurée pour émettre ladite lumière d'excitation prédéterminée, et un détecteur de lumière configuré de façon à recevoir, en provenance dudit composant sensible, de la lumière par fluorescence, et de façon à détecter l'intensité de la lumière par fluorescence reçue.

Le dispositif selon l'invention est moins coûteux à mettre en oeuvre que les dispositifs de mesure traditionnels utilisant un détecteur thermique infrarouge. En effet, un détecteur de lumière dont la bande spectrale est comprise dans la bande du visible (et donc moins onéreux) est adapté à la détection de la lumière par fluorescence pouvant être réémise par le composant sensible.

Selon un aspect particulier de l'invention, le dispositif comprend un filtre spectral configuré de façon à empêcher la lumière d'excitation en provenance du composant sensible ou de la source de lumière, d'être reçue par le capteur de lumière. On augmente ainsi le rapport signal sur bruit du signal de fluorescence détecté par le détecteur de lumière, ce qui permet d'obtenir des mesures de champ électromagnétique plus précises.

Selon un mode de mise en oeuvre particulier, le dispositif comprend une fibre optique multicanaux dont une première extrémité est reliée à une face du composant sensible, une deuxième extrémité est reliée à un module comprenant ledit détecteur de lumière et ladite source de lumière d'excitation. Une telle configuration permet de réaliser des mesures ponctuelles de champ électromagnétique.

Dans un autre mode de réalisation particulier de l'invention, il est proposé un procédé de mesure d'un champ électromagnétique au moyen d'un composant sensible tel que défini dans la revendication indépendante 9.

Le procédé comprend une étape consistant à soumettre ledit composant sensible au champ électromagnétique de sorte que ledit premier matériau absorbe partiellement une énergie du champ électromagnétique et convertit l'énergie absorbée en chaleur et que ledit deuxième matériau, placé en contact avec ledit premier matériau, emmagasine la chaleur convertie par ledit premier matériau. L'étape consistant à exposer ledit composant sensible à une lumière d'excitation prédéterminée est effectuée de sorte que ledit deuxième matériau réémette une lumière par fluorescence d'intensité lumineuse dépendant de la chaleur emmagasinée.

Ainsi, l'invention propose un nouveau procédé de mesure de champ électromagnétique par thermofluorescence. Ainsi, le caractère innovant réside dans le fait de corréler l'intensité de fluorescence détectée à la température du composant sensible (c'est-à-dire à la chaleur emmagasinée) pour réaliser une mesure du champ électromagnétique. Par « mesure du champ électromagnétique », on entend le fait de mesurer un champ électrique et/ou un champ magnétique.

Cet autre mode de réalisation particulier peut être vu comme une utilisation du composant sensible pour la mise en oeuvre d'une mesure de champ électromagnétique : soumission du composant sensible au champ électromagnétique à mesurer, exposition du composant sensible à la lumière d'excitation pour activer ses propriétés de fluorescence, détection de lumière par fluorescence réémise le composant sensible et réalisation d'une mesure du champ électromagnétique en fonction de l'intensité de la lumière par fluorescence qui a été détectée.

Dans un autre mode de réalisation particulier de l'invention, il est proposé un procédé de fabrication d'un composant sensible à un champ électromagnétique tel que défini dans la revendication indépendante 10.

Selon une mise en oeuvre particulière, l'étape de formation consiste à appliquer une solution vaporisable au sein de laquelle lesdits premier et deuxième matériaux sont mélangés de manière homogène, de façon à former une couche d'un mélange homogène desdits premier et deuxième matériaux.

Cette étape de formation des premier et deuxième matériaux est particulièrement simple à mettre en oeuvre. L'utilisation d'une solution vaporisable permet de disposer d'un composant sensible « prêt à l'emploi » pour la mesure de champ électromagnétique sans avoir recours à une machinerie ou technique de dépôt encombrante, complexe et coûteuse. Cette étape permet en outre d'adapter plus aisément la mesure de champ électromagnétique à tout type d'objet (et notamment à des objets de forme complexe sur lesquels il est difficile de placer un capteur).

Selon une variante de mise en oeuvre, l'étape de formation consiste à appliquer successivement une première solution vaporisable comprenant ledit premier matériau et une deuxième solution vaporisable comprenant ledit deuxième matériau sur la première solution appliquée, de façon à former une structure en couches superposées desdits premier et deuxième matériaux.

Cette étape de formation des premier et deuxième matériaux est particulièrement simple à mettre en oeuvre. L'utilisation d'une solution vaporisable permet de disposer d'un composant sensible « prêt à l'emploi » pour la mesure de champ électromagnétique sans avoir recours à une machinerie ou technique de dépôt encombrante, complexe et coûteuse. Cette étape permet en outre d'adapter plus aisément la mesure de champ électromagnétique à tout type d'objet (notamment à des objets de forme complexe.

Selon une autre variante de mise en oeuvre, l'étape de formation consiste à déposer une solution de dépôt au sein de laquelle lesdits premier et deuxième matériaux sont mélangés, de façon à former une couche d'un mélange homogène desdits premier et deuxième matériaux. Des techniques de dépôt, telles que par enduction centrifuge (« spin-coating »), trempage (« dip-coating »), évaporation de goutte (« drop-casting ») ou analogue, conviennent parfaitement pour mettre en oeuvre cette étape du procédé.

Selon une autre variante de mise en oeuvre, l'étape de formation consiste à déposer successivement une première couche dudit premier matériau et une deuxième couche dudit deuxième matériau sur ladite première couche, de façon à former une structure en couches superposées desdits premier et deuxième matériaux. Des techniques de dépôt, telles que par enduction centrifuge (« spin-coating »), trempage (« dip-coating »), évaporation de goutte (« drop-casting ») ou analogue, conviennent parfaitement pour mettre en oeuvre cette étape du procédé.

Dans un autre mode de réalisation de l'invention, il est proposé un produit programme d'ordinateur qui comprend des instructions de code de programme pour la mise en oeuvre du procédé de mesure précité (dans l'un quelconque de ses différents modes de réalisation), lorsque ledit programme est exécuté sur un ordinateur.

Selon un aspect hors invention, il est proposé un médium de stockage lisible par ordinateur et non transitoire, stockant un programme d'ordinateur comprenant un jeu d'instructions exécutables par un ordinateur pour mettre en oeuvre le procédé de mesure précité (dans l'un quelconque de ses différents modes de réalisation).

## 5. LISTE DES FIGURES

D'autres caractéristiques et avantages de l'invention apparaîtront à la lecture de la description suivante, donnée à titre d'exemple indicatif et non limitatif, et des dessins annexés, dans lesquels :

- la figure 1 présente un synoptique d'un dispositif de mesure selon un premier mode de réalisation particulier de l'invention ;
- la figure 2 présente la structure schématique simplifiée d'un composant sensible selon une première mise en oeuvre particulière de l'invention ;
- la figure 3 présente la structure schématique simplifiée d'un composant sensible selon une deuxième mise en oeuvre particulière de l'invention ;
- la figure 4 présente la structure schématique simplifiée d'un composant sensible selon une troisième mise en oeuvre particulière de l'invention ;
- la figure 5 présente un synoptique d'un dispositif de mesure selon un deuxième mode de réalisation particulier de l'invention ;
- la figure 6 présente un organigramme générique d'un mode de réalisation particulier du procédé selon l'invention ;
- la figure 7 présente la structure d'une unité de traitement mettant en oeuvre le procédé de mesure selon un mode de réalisation particulier de l'invention.

## 6. DESCRIPTION DÉTAILLÉE

Sur toutes les figures du présent document, les éléments et étapes identiques sont désignés par une même référence numérique.

Le principe de l'invention repose sur une approche astucieuse consistant à associer un premier matériau ayant des propriétés d'absorption et d'échauffement de champ électromagnétique avec un second matériau ayant des propriétés de thermofluorescence pour réaliser des mesures de champ électromagnétique.

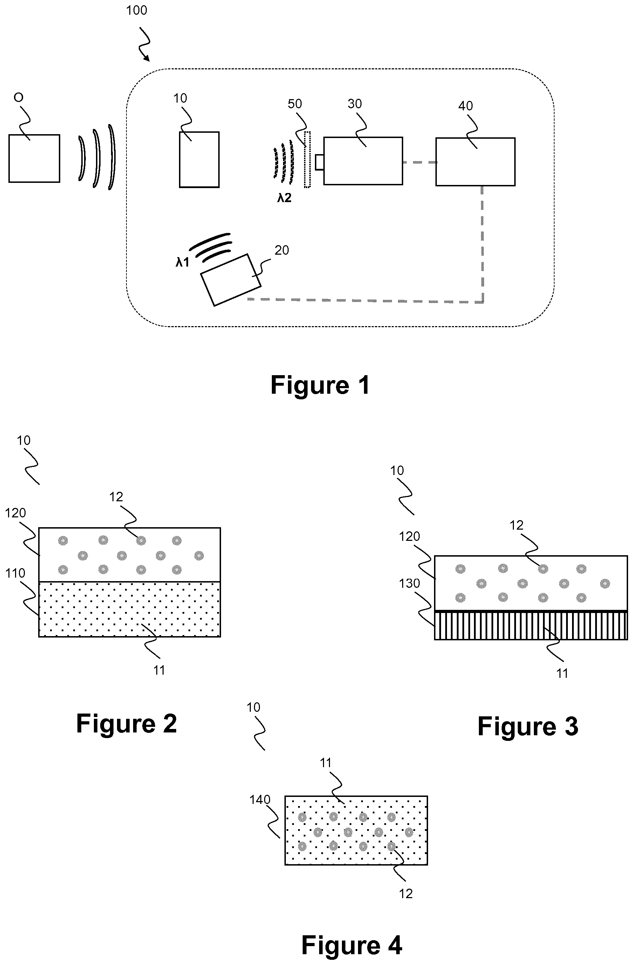

On présente, en relation avec la **figure 1**, un synoptique d'un dispositif de mesure (ou capteur) 100 selon un premier mode de réalisation particulier de l'invention. Dans ce mode de réalisation particulier, le dispositif 100 permet de délivrer, par analyse du rayonnement de fluorescence, une image bidimensionnelle ou tridimensionnelle du champ électromagnétique produit par un objet O.

Le dispositif 100 comprend un composant sensible 10 au champ électromagnétique, une source de lumière excitatrice 20, un détecteur de lumière 30 et une unité de traitement 40. L'objet O émet un rayonnement électromagnétique radiofréquence ou hyperfréquence, compris par exemple entre 1 kHz et 10 GHz. Il peut s'agir par exemple d'une source micro-onde dédiée ou d'un système rayonnant dont on souhaite obtenir une cartographie du champ électromagnétique.

Le composant sensible 10 selon l'invention comprend un premier matériau, apte à absorber une partie de l'énergie du champ électromagnétique émis par l'objet O et à convertir cette énergie absorbée en chaleur (on parle aussi d'échauffement ou d'élévation de température du matériau), dit matériau absorbant, et un deuxième matériau, fluorescent et thermosensible, placé en contact avec le matériau absorbant, dit matériau fluorescent.

On entend par « matériau absorbant », un matériau absorbant partiellement l'énergie du champ électromagnétique, c'est-à-dire absorbant entre 1% et 20% de l'énergie du champ électromagnétique

On entend par « placé en contact » le fait que le matériau fluorescent est disposé par rapport au matériau absorbant de façon à ce qu'un transfert thermique s'opère du matériau absorbant vers le matériau fluorescent.

L'idée consiste ici à utiliser l'échauffement du matériau absorbant l'énergie du champ électromagnétique émis par l'objet O et l'associer au matériau fluorescent qui est capable de récupérer et d'emmagasiner la chaleur convertie par le matériau absorbant, pour permettre la caractérisation du champ électromagnétique. Le matériau fluorescent du composant 10 émet de la lumière par fluorescence (aussi parfois appelée « lumière fluorescente ») sous l'action d'une lumière d'excitation de longueur d'onde donnée. Ainsi, par analyse de l'intensité de lumière par fluorescence réémise par le matériau fluorescent, qui dépend de la variation de température du matériau absorbant, il est possible de mesurer l'amplitude du champ électrique ou magnétique.

Le matériau fluorescent typiquement utilisé appartient à la famille des fluorophores émettant dans le domaine du visible (approximativement 400 nm à 800 nm). Le matériau fluorescent choisi ici à titre d'exemple pour la suite de la description est le composé chimique appelé Rhodamine B dont la longueur d'onde de fluorescence est centrée autour de 600 nm à la température ambiante (notée $\lambda_2$ par la suite) lorsque ce composé est soumis à une lumière de longueur d'onde 470 nm (notée $\lambda_1$ par la suite). Bien entendu, il s'agit là d'un exemple purement illustratif et on pourrait prévoir d'autres matériaux qui sont à la fois fluorescents et thermosensibles. De manière générale, on privilégiera un matériau fluorescent excitable sous une longueur d'onde comprise entre 300 et 500 nm, et émettant une lumière par fluorescence comprise entre 400 et 800 nm. Par ailleurs, on choisira un matériau fluorescent qui est thermosensible dans une plage comprise entre -200 et +300 degrés Celsius, et plus précisément entre 10 et 40 degrés Celsius.

Le matériau absorbant utilisé dépend de la nature du champ (électrique ou magnétique) que l'on souhaite mesurer. En pratique, pour éviter que le matériau absorbant ne perturbe le champ électromagnétique émis par l'objet, celui-ci est choisi de façon à ce qu'il n'absorbe, pour une plage de fréquences électromagnétiques donnée, qu'une partie seulement de l'énergie électromagnétique, mais néanmoins suffisante pour générer un échauffement (c'est-à-dire une augmentation de la température) dudit matériau perceptible par le matériau fluorescent.

Quand le dispositif de mesure 100 est en fonctionnement, la source de lumière 20 émet la lumière d'excitation du matériau fluorescent. Dans le mode de réalisation particulier présenté ici, la source de lumière 20 est une diode électroluminescente qui émet une lumière bleue de longueur d'onde $\lambda_1$ égale à 470 nm. Le détecteur de lumière 30, par exemple une caméra CCD ou CMOS sensible à l'ensemble du spectre de la lumière visible, détecte en provenance du composant sensible 10 l'intensité de la lumière visible qu'il reçoit et la convertit en signal électrique à destination de l'unité de traitement 40. L'unité de traitement 40 est raccordée électriquement au détecteur de lumière 30 d'une part et à la source de lumière 20 d'autre part. Le filtre spectral 50, par exemple de type passe-haut 550 nm, est associé au détecteur de lumière 30 de façon à empêcher la lumière d'excitation (de longueur d'onde $\lambda_1$) en provenance de la source de lumière 20 (directement ou par réflexion) d'être reçue par le détecteur de lumière 30, et donc à recevoir la lumière de florescence, de longueur d'onde $\lambda_2$, réémise par le matériau fluorescent.

L'utilisation d'un matériau fluorescent dans la bande spectrale du visible (comprise approximativement entre 400 et 800 nm) offre la possibilité d'utiliser un détecteur de lumière sensible à cette bande spectrale, qui présente l'avantage d'être moins coûteux que les détecteurs de lumière infrarouge utilisés dans les solutions de l'art antérieur.

On présente, en relation avec les **figures 2, 3 et 4,** trois exemples de mise en oeuvre du composant sensible 10 selon l'invention. Le matériau absorbant et le matériau fluorescent sont référencés 11 et 12 respectivement sur ces figures.

Première mise en oeuvre particulière (figure 2)

Selon une première mise en oeuvre particulière, le composant sensible 10 se présente sous la forme d'une structure en couches minces superposées. Cette structure comprend une couche 110 de matériau absorbant 11 sur laquelle s'étendant une couche mince 120 de matériau fluorescent 12. Par exemple, la couche 120 est une couche mince de Rhodamine B, d'épaisseur comprise entre 1 et 10 $\mu$m, déposée (par enduction centrifuge par exemple) sur une couche mince de matériau composite absorbant, tel que le Kapton® ou le Tokin® par exemple, d'épaisseur comprise entre 10 et 500 $\mu$m. Le Kapton® est un matériau constitué d'une matrice polymérique chargée en particules de carbone, particulièrement bien adapté à la mesure de champ électrique. Le Tokin® est un matériau constitué d'une matrice polymérique chargée en particules ferromagnétiques, particulièrement bien adapté à la mesure de champ magnétique.

Bien sûr, il s'agit là encore d'exemples purement illustratifs. Pour la mesure de champ électrique, un matériau composite à base d'une matrice électriquement isolante et de particules électriquement conductrices peut être tout à fait envisagé. Pour la mesure de champ magnétique, un matériau composite à base d'une matrice électriquement isolante et de particules magnétiques peut être tout à fait envisagé. Ainsi, on pourrait envisager d'intégrer au composant sensible un matériau absorbant composite intégrant à la fois une charge électrique et une charge magnétique pour réaliser une mesure complète du champ électromagnétique.

A noter que la charge particulaire électriquement conductrice doit être ajustée de façon à ce que le matériau absorbant présente une « faible » impédance de surface, c'est-à-dire une impédance de surface comprise entre 500 et 3000 $\Omega$, afin qu'il n'absorbe qu'une partie seulement du champ électrique. Cette impédance de surface est ajustée en fonction de la concentration de particules dans la matrice isolante et de l'épaisseur de la couche de matériau absorbant.

Cette structure en couches superposées selon l'invention peut être réalisée de différentes manières.

Une première manière de faire consiste à déposer successivement une première couche 110 du matériau absorbant 11 et une deuxième couche 120 du matériau fluorescent 12 sur la première couche 110, de façon à former la structure en couches superposées telle qu'illustrée sur la figure 2. Pour se faire, la couche mince 110 de matériau absorbant est préalablement déposée sur un substrat (non représenté sur la figure) électriquement et/ou magnétiquement neutre (autrement dit transparent aux ondes électriques et/ou magnétiques en fonction de la nature de la mesure à réaliser) par une technique de dépôt classique telle que par enduction centrifuge (*« spin-coating »*), trempage (*« dip-coating »*) ou évaporation de goutte (*« drop-casting »*) par exemple. Puis la couche mince 120 de matériau fluorescent est déposée sur la couche mince 110 de matériau absorbant également par une technique de dépôt classique. Afin d'éviter de réduire tout risque de perturbations électromagnétiques, un dépôt de couches minces sans substrat peut être privilégié.

Une deuxième manière de faire consiste à appliquer successivement sur une surface de l'objet O, une première solution vaporisable de matériau absorbant 11 et une deuxième solution vaporisable de matériau fluorescent 12, de façon à former la structure en couches superposées telle qu'illustrée sur la figure 2. L'utilisation d'une solution vaporisable permet de disposer d'un composant sensible « prêt à l'emploi » qui s'adapte à tout type d'objet à caractériser. Elle évite notamment d'avoir recours à une machinerie ou technique de dépôt encombrante et inadaptée à la caractérisation de certains objets. Enfin, elle évite l'emploi d'un substrat qui pourrait être sensiblement perturbateur vis-à-vis du champ électromagnétique à mesurer.

Deuxième mise en oeuvre particulière (figure 3)

Selon une deuxième mise en oeuvre particulière, à la différence de la première mise en oeuvre, la couche mince 120 est déposée (par enduction centrifuge par exemple) sur une couche structurée ferromagnétique (« *ferromagnetic patterned layer»* en anglais) 130. Cette couche structurée 130 comprenant un réseau périodique de plots ferromagnétiques uniformément répartis à la surface du substrat, chaque plot faisant saillie à partir de la surface du substrat. La forme, le nombre et la disposition des plots, ainsi que la proportion de surface occupée par ces derniers peuvent être adaptés au cas par cas, en fonction notamment des pertes diélectriques et/ou magnétiques souhaitées dans la couche du matériau absorbant utilisé.

Cette couche structurée a une épaisseur de préférence comprise entre 100 et 500 nm, et est obtenue par exemple au moyen d'une technique de pulvérisation cathodique d'un alliage Fe-Nickel. D'autres matériaux absorbants magnétiques, adaptés à la mise en oeuvre d'une couche structurée, peuvent bien entendu être utilisés sans sortir du cadre de l'invention.

Cette mise en oeuvre est particulièrement bien adaptée à la mesure de champ magnétique.

Troisième mise en oeuvre particulière (figure 4)

Selon une troisième mise en oeuvre particulière, le composant sensible 10 se présente sous la forme d'une couche mince 140 au sein de laquelle les matériaux absorbant 11 et fluorescent 12 sont mélangés de manière homogène. La couche mince 140 présente une épaisseur comprise typiquement entre 10 et 500 $\mu$m, par exemple 50 $\mu$m. Cette configuration particulière permet une diffusion efficace de l'énergie thermique du matériau absorbant 11 vers le matériau fluorescent 12, rendant la mesure de champ électromagnétique plus précise.

Comme décrit précédemment, un composite à base d'une matrice électriquement isolante et de particules électriquement conductrices peut être utilisé en tant que matériau absorbant pour la mesure de champ électrique. Un composite à base d'une matrice électriquement isolante et de particules magnétiques (par exemple de type ferromagnétiques) peut être utilisé pour la mesure de champ magnétique. Toutefois, dans cette mise en oeuvre particulière, le composite comprend également le matériau fluorescent 12, par exemple un fluorophore tel que la Rhodamine B.

Cette couche de mélange de matériaux selon l'invention peut être formée de différentes manières.

Une première manière de faire consiste à déposer sur un substrat, par enduction centrifuge ou trempage-étirage, une solution de dépôt au sein de laquelle le matériau absorbant 11 (composite polymère chargé en particules magnétique par exemple) et le matériau fluorescent 12 (un fluorophores à base de terre rares ou à base de Rhodamine B par exemple) sont mélangés, de façon à former la couche de mélange 140. Des techniques de dépôt, telles que par évaporation de goutte ou analogue, conviennent parfaitement pour mettre en oeuvre cette étape du procédé. Le substrat à utiliser doit être sensiblement transparent au champ électromagnétique rayonné par l'objet O.

Une deuxième manière de faire consiste à appliquer, sur une surface de l'objet O, une solution vaporisable au sein de laquelle les matériaux absorbant 11 et fluorescent 12 sont mélangés de manière homogène, de façon à former la couche de mélange 140. L'utilisation d'une solution vaporisable permet de disposer d'un composant sensible « prêt à l'emploi » qui s'adapte à tout type d'objet à caractériser. Elle évite notamment d'avoir recours à une machinerie ou technique de dépôt encombrante et inadaptée à la caractérisation de certains objets. Enfin, elle évite l'utilisation d'un substrat qui pourrait être sensiblement perturbateur vis-à-vis du champ électromagnétique à mesurer.

Selon l'invention, le matériau fluorescent 12 comprend non pas un composé mais plusieurs composés ou molécules fluorescent(e)s chacun(e) apte à émettre une lumière par fluorescence de longueur d'onde distincte. A titre d'exemple, on pourrait envisager un premier composé fluorophore émettant une lumière par fluorescence de longueur d'onde $\lambda_2$ et un deuxième composé fluorophore émettant une lumière par fluorescence de longueur d'onde $\lambda_3$ lorsque ces deux composés sont soumis à la lumière d'excitation $\lambda_1$. Le rapport des deux intensités de lumière par fluorescence, chacune associée à une longueur d'onde distincte, est directement proportionnel à la température du matériau.

Bien sûr, le dispositif de mesure 200 peut être équipé si besoin d'une deuxième source de lumière d'excitation dédiée au deuxième composé fluorophore dans le cas où la première source de lumière d'excitation 20 ne permet pas de faire fluorescer le deuxième composé du matériau fluorescent 12.

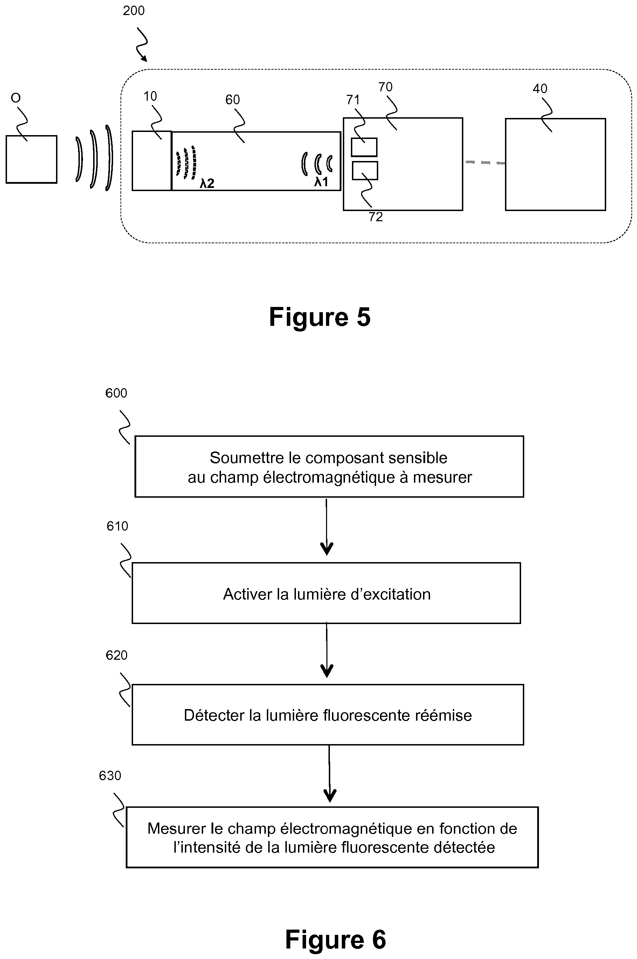

On présente, en relation avec la **figure 5**, un synoptique d'un dispositif de mesure 200 selon un deuxième mode de réalisation particulier de l'invention. Dans ce mode de réalisation particulier, le dispositif 200 permet de réaliser une mesure ponctuelle (ou locale) du champ électromagnétique.

Dans ce mode de réalisation particulier, le dispositif 200 comprend un composant sensible 10 précité (dans l'un quelconque de ses différents modes de mise en oeuvre), un module d'émission/réception 70, une unité de traitement 80 et une fibre optique multicanaux 60 dont une première extrémité est reliée à une face du composant sensible 10 et une deuxième extrémité est reliée au module d'émission/réception 70. Le module d'émission/réception 70 est équipé d'une source de lumière 71 d'excitation de longueur d'onde $\lambda_1$ (une diode électroluminescente par exemple) et d'un détecteur de lumière 72 (un spectromètre ou une photodiode par exemple) sensible dans la bande spectrale du visible. L'unité de traitement 80 est raccordée électriquement au module d'émission/réception 70. L'unité de traitement 80 est identique à l'unité de traitement 40 de la figure 1.

La fibre optique 60 comprend un premier canal optique configuré pour véhiculer la longueur d'onde d'excitation $\lambda_1$ (avec $\lambda_1$ = 470 nm par exemple) générée par la source de lumière d'excitation 71, et un deuxième canal optique configuré pour véhiculer la longueur d'onde de fluorescence $\lambda_2$ (avec $\lambda_2$ = 600 nm par exemple) réémise par le matériau fluorescent soumis à l'excitation jusqu'au détecteur de lumière 72. Selon une implémentation particulière, le premier canal optique est placé longitudinalement en périphérie de la fibre optique et le deuxième canal longitudinalement au coeur de la fibre optique.

Selon une caractéristique particulière, un canal optique supplémentaire pourrait être mis en oeuvre au sein la fibre optique 60 pour véhiculer une deuxième longueur d'onde de fluorescence ($\lambda_3$), par exemple dans le cas où la lumière par fluorescence réémise par le matériau fluorescent 12 présente deux longueurs d'onde distinctes (présence de deux composés ou molécules de fluorophore dans le matériau fluorescent 12). Dans ce cas, on pourrait envisager d'intégrer dans le module 70 un filtre spectral coopérant avec ce canal optique supplémentaire afin de prendre en compte cette deuxième longueur d'onde de fluorescence.

Quand le dispositif de mesure 200 est en fonctionnement, le module d'émission/réception 70 expose, via le premier canal optique, le matériau fluorescent 12 compris dans le composant sensible 10 à la lumière d'excitation de longueur d'onde $\lambda_1$. Sous l'action de la lumière d'excitation, le matériau fluorescent 12 émet, via le deuxième canal optique, de la lumière par fluorescence de longueur d'onde $\lambda_2$ qui est ensuite détectée par le détecteur contenu dans le module d'émission/réception 70. L'intensité de la lumière par fluorescence détectée dépendant de la température du matériau fluorescent 12 permet de déterminer l'amplitude du champ électromagnétique. Comme pour le premier mode de réalisation, le procédé de mesure est effectué par l'unité de traitement du dispositif de mesure, dont le principe est détaillé ci-après en relation avec la figure 6.

Grâce à sa fibre optique, le dispositif de mesure 200 présente l'avantage de pouvoir être inséré dans un corps ou un dispositif pour y mesurer le champ électromagnétique.

On décrit ci-après, en relation avec la **figure 6**, les étapes principales du procédé de mesure selon un mode de réalisation particulier de l'invention. Dans ce mode de réalisation, le procédé est effectué par l'unité de traitement 40. L'unité de traitement 40 est configurée pour piloter la source de lumière 20 et le détecteur de lumière 30, et pour déterminer l'amplitude du champ électromagnétique en fonction des signaux lumineux reçu par le détecteur de lumière 20.

A noter que si l'objet O est une source micro-onde dédiée, celle-ci peut être pilotée également par l'unité de traitement 40 (via une liaison électrique ou sans-fil).

A l'étape 600, le composant sensible 10 est soumis au champ électromagnétique produit par l'objet O. Comme expliqué plus haut, le matériau absorbant 11 absorbe une partie de l'énergie du champ électromagnétique produit par l'objet O et la convertit en chaleur. Le matériau fluorescent 12, en contact avec le matériau absorbant 11, emmagasine alors la chaleur convertie par le matériau absorbant 11.

A l'étape 610, l'unité de traitement 40 active la source de lumière 20 de façon à exposer le composant sensible 10 à la lumière d'excitation de longueur d'onde $\lambda_1$. Le matériau fluorescent 12 émet alors une lumière par fluorescence de longueur d'onde $\lambda_2$ dont l'intensité lumineuse dépend de la température.

A l'étape 620, l'unité de traitement 40 active le détecteur de lumière 30 de façon à capter la lumière par fluorescence de longueur d'onde $\lambda_2$ réémise par le matériau fluorescent 12 lors de l'exposition du composant sensible 10 à la lumière d'excitation.

A l'étape 630, l'unité de traitement 40 mesure le champ électromagnétique en fonction de l'intensité de la lumière par fluorescence reçue par le détecteur de lumière 30 (notée ci-après $I_{fluo}$).

Les inventeurs de la présente exploitent le fait que l'intensité de lumière de fluorescence d'un matériau fluorescent thermosensible est intimement liée à sa température. Ainsi, c'est la variation de température ($\Delta T$) donnée par la variation d'intensité de lumière de fluorescence détectée ($I_0 - I_{fluo}$) qui permet d'estimer l'amplitude du champ électrique (E).

(i) Mesure et cartographie du champ électrique :

Pour estimer l'amplitude du champ électrique (E), il faut dans un premier temps connaître la relation qui relie ce champ électrique à la densité surfacique de puissance électrique ($P_{abs}$) absorbée par un matériau absorbant soumis à l'onde électrique. Cette relation est donnée par l'équation suivante :

$$P_{abs} = \frac{2Z_s}{(2Z_s + Z_0)} E^2 \qquad (1)$$

avec :

Z_S, l'impédance de surface du matériau absorbant (en $\Omega$) ;
$Z_0$, l'impédance du vide (en $\Omega$) ;
E, l'amplitude du champ électrique à laquelle le matériau absorbant est soumis (en V/m).

Par ailleurs, la densité surfacique de puissance électrique absorbée est, elle-même, liée à la variation de température ($\Delta T$) à laquelle est soumis le matériau (c'est-à-dire la quantité de chaleur emmagasinée par le matériau) selon la formulation suivante :

$$\Delta T = \frac{P_{abs}}{2h} \qquad (2)$$

avec :

$P_{abs}$, la densité surfacique de puissance électrique absorbée par le matériau absorbant (en W/m²) ; $h$, le coefficient de convection (en W/m²K).

Certains matériaux fluorescents émettent une lumière dont l'intensité de lumière de fluorescence varie en fonction de leur température. Cette dépendance peut s'exprimer de la façon suivante :

$$\Delta T = f(\Delta I) \qquad (3)$$

avec :

$\Delta T$, la différence entre la température du matériau absorbant en l'absence de champ électrique ($T_0$) et la température du matériau absorbant en présence de champ électrique ($T_1$) ;
$\Delta I$, la différence entre l'intensité de lumière de fluorescence mesurée en l'absence de champ électrique ($I_0$) et l'intensité de lumière de fluorescence mesurée en présence de champ électrique ($I_{fluo}$);
$f$, une fonction monotone définissant le comportement de thermofluorescence du matériau fluorescent et dont les caractéristiques sont obtenues de manière empirique.

Dans le cas d'un matériau fluorescent à base de Rhodamine B par exemple, l'intensité de la lumière de fluorescence varie de l'ordre de -1 % par degré Celsius.

A partir des équations (1), (2) et (3) ci-dessus, l'unité de traitement 40 réalise une estimation de l'amplitude $E$ du champ électrique (en V/m) à laquelle est soumis le composant sensible 10 à l'aide de l'équation suivante :

$$E = \sqrt{\frac{I_0 - I_{fluo}}{a}} \qquad (4)$$

avec :

$I_{fluo}$, l'intensité de lumière par fluorescence détectée par le détecteur de lumière 30 en présence de champ électrique (en W/m²);
$I_0$, l'intensité de lumière par fluorescence détectée par le détecteur de lumière 30 en l'absence de champ électrique (intensité dite de référence exprimée en W/m²) ;
$a$, un coefficient de calibration pour la mesure de champ électrique, dépendant de la fonction f et des paramètres $h$, $Z_s$, $Z_0$.

La valeur du coefficient de calibration $a$ est obtenue, en pratique, par calibration du dispositif de mesure.

Ainsi, la présente invention propose une mesure du champ électrique par simple mesure d'intensité de lumière de fluorescence émise par le composant sensible 10. L'unité de traitement 40 traite l'ensemble des données relatives à l'intensité de fluorescence mesurée par le détecteur de lumière et délivre ensuite une cartographie du champ électrique émis par l'objet O.

(ii) Mesure et cartographie du champ magnétique :

Pour estimer l'amplitude du champ magnétique ($H$), il faut dans un premier temps connaître la relation qui relie ce champ magnétique à la densité surfacique de puissance magnétique ($P_{abs}$) absorbée par un matériau absorbant soumis à l'onde magnétique. Cette relation est donnée par l'équation suivante :

$$P_{abs} = \mu_0.\pi.\chi''(H). \, v. \, H^2.e \qquad (5)$$

avec :

$H$, l'amplitude du champ magnétique à laquelle est soumis le matériau absorbant (en A/m) ;
$v$, la fréquence du champ magnétique à laquelle est soumis le matériau absorbant (en Hz) ;
$\chi''(H)$, la partie imaginaire de la susceptibilité magnétique (sans unité) ;
$\mu_0$, la perméabilité magnétique du vide (kg.m.A$^{-2}$ s$^{-2}$) ; et
$e$, l'épaisseur du film (en m).

Considérons, comme précédemment à titre d'exemple, l'utilisation d'un matériau fluorescent à base de Rhodamine B. Ainsi, à partir des équations (2), (3) et (5) ci-dessus, l'unité de traitement 40 réalise une estimation de l'amplitude H du champ magnétique (en A/m) à laquelle est soumis le composant sensible 10 à l'aide de l'équation suivante :

$$H = \sqrt{\frac{I_0 - I_{fluo}}{b}} \qquad (6)$$

avec :

$I_{fluo}$, l'intensité de lumière par fluorescence détectée par le détecteur de lumière 30 en présence de champ magnétique (en W/m²);
$I_0$, l'intensité de lumière par fluorescence détectée par le détecteur de lumière 30 en l'absence de champ magnétique (intensité dite de référence exprimée en W/m²) ;
$b$, un coefficient de calibration pour la mesure de champ magnétique, dépendant de la fonction f et des paramètres $h$, $\chi''(H)$ et v.

La valeur du coefficient de calibration b est obtenue, en pratique, par calibration du dispositif de mesure.

Ainsi, la présente invention propose une mesure du champ magnétique par simple mesure d'intensité de lumière de fluorescence émise par le composant sensible 10. L'unité de traitement 40 traite l'ensemble des données relatives à l'intensité de fluorescence mesurée par le détecteur de lumière et délivre ensuite une cartographie du champ magnétique émis par l'objet O.

Ainsi, le principe ici est d'utiliser le composant sensible à des fins de mesures du champ électromagnétique (le soumettre au champ électromagnétique, l'exposer à une lumière d'excitation, détecter la fluorescence réémise par celui-ci).

Dans le cas particulier où le matériau fluorescent 12 comprend une pluralité de composés fluorescents, tel que par exemple un premier composé fluorophore émettant une lumière par fluorescence de longueur d'onde $\lambda_2$ et un deuxième composé fluorophore émettant une lumière par fluorescence de longueur d'onde $\lambda_3$ lorsque soumis à la lumière d'excitation. Dans ce cas, la dépendance de l'intensité de lumière de fluorescence et de la température peut s'exprimer de la façon suivante :

$$T = f'(\frac{I_2}{I_3})$$

avec:

I₂, l'intensité de lumière de fluorescence émise par le premier composé fluorophore ;

I₃, l'intensité de lumière de fluorescence émise par le deuxième composé fluorophore ; f', une fonction monotone définissant le comportement de thermofluorescence du matériau fluorescent comprenant les premier et deuxième composés fluorophores et dont les caractéristiques sont obtenues expérimentalement d'après les propriétés physiques de ces deux composés.

Le rapport des deux intensités de lumière par fluorescence, est directement proportionnel à la température du matériau, ce qui permet de déduire l'amplitude du champ électrique ou magnétique émis par l'objet O. D'autres méthodes pour estimer la température d'un composant sensible multi-fluorophore par fluorescence peuvent être utilisées en vue de mesurer le champ électromagnétique associé, sans sortir du cadre de l'invention. A titre d'exemple, on pourrait envisager d'effectuer une estimation de la température du composant sensible en se basant sur ses caractéristiques spectrales. On pourrait établir la fonction monotone discutée ci-dessus sur la base du rapport des largeurs de bande spectrale à mi-hauteur (aussi appelées FWHM en anglais pour « *Full Width of Half Maximum* ») des pics de lumières de fluorescence émis par les composés fluorophores et de leur décalage en longueur d'onde.

Selon une mise en oeuvre particulière, côté émission, l'unité de traitement 40 effectue une modulation en amplitude de la lumière d'excitation, et côté réception, l'unité de traitement 40 effectue, de manière synchrone, une démodulation la lumière de fluorescence détectée par le détecteur de lumière. Le fait de coupler une modulation optique de la lumière d'excitation avec une démodulation de la mesure d'intensité de fluorescence permet d'augmenter le rapport signal sur bruit du signal optique détecté par le détecteur de lumière, et ainsi d'améliorer la précision de mesure d'intensité de fluorescence.

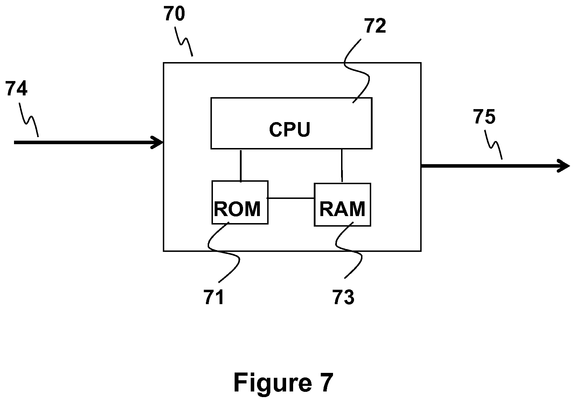

La **figure 7** présente la structure simplifiée d'une unité de traitement mettant en oeuvre le procédé de mesure selon l'invention (par exemple le premier mode de réalisation particulier décrit ci-dessus en relation avec la figure 1). Ce module comprend une mémoire vive 73 (par exemple une mémoire RAM), un bloc de traitement 72, équipée par exemple d'un processeur, et pilotée par un programme d'ordinateur stocké dans une mémoire morte 71 (par exemple une mémoire ROM ou un disque dur). A l'initialisation, les instructions de code du programme d'ordinateur sont par exemple chargées dans la mémoire vive 73 avant d'être exécutées par le processeur du bloc de traitement 72. Le bloc de traitement 72 reçoit des instructions d'initialisation du procédé (flèche 74), et active la source de lumière (pour exposer/exciter le composant sensible) et le détecteur de lumière du dispositif de mesure (pour détecter la lumière par fluorescence réémise par le composant sensible (pouvant être composée de plusieurs longueurs d'onde distinctes en fonction du nombre de composés fluorescents compris dans le matériau fluorescent thermosensible)). Le processeur du bloc de traitement 72 traite les informations relatives à la lumière de fluorescence détectée par le détecteur de lumière et délivre en sortie une cartographie bidimensionnelle ou tridimensionnelle du champ électromagnétique (flèche 75), selon les instructions du programme.

Cette figure 7 illustre seulement une manière particulière, parmi plusieurs possibles, de réaliser l'algorithme détaillé ci-dessus, en relation avec la figure 6. En effet, le procédé de mesure de l'invention se réalise indifféremment :

- sur une machine de calcul reprogrammable (un ordinateur PC, un processeur DSP ou un microcontrôleur) exécutant un programme comprenant une séquence d'instructions, ou
- sur une machine de calcul dédiée (par exemple un ensemble de portes logiques comme un FPGA ou un ASIC, ou tout autre module matériel).

Dans le cas où l'invention est implantée sur une machine de calcul reprogrammable, le programme correspondant (c'est-à-dire la séquence d'instructions) pourra être stocké dans un médium de stockage amovible (tel que par exemple une disquette, un CD-ROM ou un DVD-ROM) ou non, ce médium de stockage étant lisible partiellement ou totalement par un ordinateur ou un processeur.

Ainsi, le terme « module » peut correspondre dans ce document aussi bien à un composant logiciel, qu'à un composant matériel ou à un ensemble de composants matériels et logiciels.

## Revendications

1. Composant sensible (10) à un champ électromagnétique, comprenant :

   - un premier matériau absorbant (11), apte à absorber une énergie d'un champ électromagnétique donné et à convertir l'énergie absorbée en chaleur ;
   - un deuxième matériau fluorescent et thermosensible (12), placé en contact avec ledit premier matériau de façon à emmagasiner la chaleur convertie par ledit premier matériau, ledit deuxième matériau étant apte à réémettre, sous l'action d'une lumière d'excitation prédéterminée, une lumière par fluorescence d'intensité lumineuse dépendant de la chaleur emmagasinée,

   ledit composant étant **caractérisé en ce que** ledit deuxième matériau comprend une pluralité de composés fluorescents chacun apte à réémettre une lumière par fluorescence de longueur d'onde distincte.

2. Composant selon la revendication 1, **caractérisé en ce qu'**il se présente sous la forme d'une structure en couches superposées comprenant une première couche dudit premier matériau (11) et une deuxième couche dudit deuxième matériau (12) s'étendant sur ladite première couche.

3. Composant selon la revendication 1, **caractérisé en ce qu'**il se présente sous la forme d'une couche au sein de laquelle lesdits premier et deuxième matériaux (11 ; 12) sont mélangés de manière homogène.

4. Composant selon l'une quelconque des revendications 1 à 3, **caractérisé en ce que** ledit premier matériau (11) est un matériau composite comprenant une matrice électriquement isolante et des particules électriquement conductrices ou magnétiques.

5. Composant selon la revendication 2, **caractérisé en ce que** la première couche est configurée sous forme d'un réseau périodique de plots dudit premier matériau (11), ledit premier matériau étant un matériau magnétique.

6. Composant selon l'une quelconque des revendications 1 à 5, **caractérisé en ce que** la lumière d'excitation prédéterminée et la lumière par fluorescence réémise par ledit deuxième matériau (12) présentent une longueur d'onde différente.

7. Dispositif de mesure (100) d'un champ électromagnétique, **caractérisé en ce qu'**il comprend un composant sensible tel que défini selon l'une quelconque des revendications 1 à 6, et **en ce qu'**il comprend en outre :

   - une source de lumière (20) configurée pour émettre ladite lumière d'excitation prédéterminée ;
   - un détecteur de lumière (30) configuré de façon à recevoir, en provenance dudit composant sensible, de la lumière par fluorescence, et de façon à détecter l'intensité de la lumière par fluorescence reçue.

8. Dispositif selon la revendication 7, **caractérisé en ce qu'**il comprend un filtre spectral (50) configuré de façon à empêcher la lumière d'excitation en provenance du composant sensible ou de la source de lumière d'être reçue par le capteur de lumière, et une fibre optique multicanaux (60) dont une première extrémité est reliée à une face du composant sensible et une deuxième extrémité est reliée à un module (70) comprenant ledit détecteur de lumière et ladite source de lumière d'excitation.

9. Procédé de mesure d'un champ électromagnétique au moyen d'un composant sensible (10) comprenant un premier matériau absorbant (11) et un deuxième matériau fluorescent et thermosensible (12), ledit deuxième matériau comprenant une pluralité de composés fluorescents chacun apte à réémettre une lumière par fluorescence de longueur d'onde distincte, ledit procédé étant **caractérisé en ce qu'**il comprend les étapes suivantes :

   - exposer (610) ledit composant sensible soumis au champ électromagnétique à une lumière d'excitation prédéterminée ;
   - détecter (620) la lumière par fluorescence réémise par ledit deuxième matériau lors de l'exposition dudit composant sensible à la lumière d'excitation prédéterminée ;
   - mesurer (630) le champ électromagnétique en fonction d'une intensité de la lumière par fluorescence détectée.

10. Procédé de fabrication d'un composant sensible à un champ électromagnétique, **caractérisé en ce qu'**il comprend une étape de formation de :

    - un premier matériau absorbant, apte à absorber une énergie du champ électromagnétique et à convertir en chaleur l'énergie absorbée ; et
- un deuxième matériau fluorescent et thermosensible, placé en contact avec ledit premier matériau de façon à emmagasiner la chaleur convertie par ledit premier matériau, ledit deuxième matériau étant apte à réémettre, sous l'action d'une lumière d'excitation prédéterminée, une lumière fluorescente d'intensité lumineuse dépendant de la chaleur emmagasinée, ledit deuxième matériau comprenant une pluralité de composés fluorescents chacun apte à réémettre la lumière par fluorescence avec une longueur d'onde distincte.

11. Procédé selon la revendication 10, **caractérisé en ce que** l'étape de formation consiste à appliquer une solution vaporisable au sein de laquelle lesdits premier et deuxième matériaux sont mélangés de manière homogène, de façon à former une couche d'un mélange homogène desdits premier et deuxième matériaux.

12. Procédé selon la revendication 10, **caractérisé en ce que** l'étape de formation consiste à appliquer successivement une première solution vaporisable comprenant ledit premier matériau et une deuxième solution vaporisable comprenant ledit deuxième matériau sur la première solution appliquée, de façon à former une structure en couches superposées desdits premier et deuxième matériaux.

13. Procédé selon la revendication 10, **caractérisé en ce que** l'étape de formation consiste déposer une solution de dépôt au sein de laquelle lesdits premier et deuxième matériaux sont mélangés, de façon à former une couche d'un mélange homogène desdits premier et deuxième matériaux.

14. Procédé selon la revendication 13, **caractérisé en ce que** l'étape de formation consiste à déposer successivement une première couche dudit premier matériau et une deuxième couche dudit deuxième matériau sur ladite première couche, de façon à former une structure en couches superposées desdits premier et deuxième matériaux.

15. Produit programme d'ordinateur, comprenant des instructions de code de programme pour la mise en oeuvre du procédé selon la revendication 9, lorsque ledit programme est exécuté sur un ordinateur.

**Patentansprüche**

1. Bauteil (10), das gegenüber einem elektromagnetischen Feld empfindlich ist, umfassend:

- ein erstes absorbierendes Material (11), das geeignet ist, Energie aus einem gegebenen elektromagnetischen Feld zu absorbieren und die absorbierte Energie in Wärme umzuwandeln,
- ein zweites fluoreszierendes und wärmeempfindliches Material (12), das mit dem ersten Material derart in Kontakt angeordnet ist, um die Wärme zu speichern, die von dem ersten Material umgewandelt wird, wobei das zweite Material geeignet ist, unter Einwirkung eines vorbestimmten Anregungslichts ein Fluoreszenzlicht mit einer Lichtstärke, die von der gespeicherten Wärme abhängig ist, zu reemittieren,

wobei das Bauteil **dadurch gekennzeichnet ist, dass** das zweite Material mehrere fluoreszierende Verbindungen umfasst, von denen jede geeignet ist, Fluoreszenzlicht mit unterschiedlicher Wellenlänge zu reemittieren.

2. Bauteil nach Anspruch 1, **dadurch gekennzeichnet, dass** es in Form einer Struktur aus übereinanderliegenden Schichten vorliegt, die eine erste Schicht aus dem ersten Material (11) und eine zweite Schicht aus dem zweiten Material (12) umfasst, die sich über die erste Schicht erstreckt.

3. Bauteil nach Anspruch 1, **dadurch gekennzeichnet, dass** es in Form einer Schicht vorliegt, in der das erste und das zweite Material (11; 12) homogen vermischt sind.

4. Bauteil nach einem der Ansprüche 1 bis 3, **dadurch gekennzeichnet, dass** das erste Material (11) ein Verbundmaterial ist, das eine elektrisch isolierende Matrix und elektrisch leitende oder magnetische Teilchen umfasst.

5. Bauteil nach Anspruch 2, **dadurch gekennzeichnet, dass** die erste Schicht in Form einer periodischen Anordnung von Pads aus dem ersten Material (11) konfiguriert ist, wobei das erste Material ein magnetisches Material ist.

6. Bauteil nach einem der Ansprüche 1 bis 5, **dadurch gekennzeichnet, dass** das vorbestimmte Anregungslicht und das Fluoreszenzlicht, das vom zweiten Material (12) reemittiert wird, eine unterschiedliche Wellenlänge aufweisen.

7. Vorrichtung zur Messung (100) eines elektromagnetischen Feldes, **dadurch gekennzeichnet, dass** sie ein empfindliches Bauteil, wie nach einem der Ansprüche 1 bis 6 definiert, aufweist und dass sie ferner aufweist:

- eine Lichtquelle (20), die konfiguriert ist, um das vorbestimmte Anregungslicht zu emittieren,
- einen Lichtdetektor (30), der derart konfiguriert ist, um Fluoreszenzlicht von dem empfindlichen Bauteil zu empfangen und derart, um die Intensität des empfangenen Fluoreszenzlichts zu erfassen.

8. Vorrichtung nach Anspruch 7, **dadurch gekennzeichnet, dass** sie einen Spektralfilter (50), der derart konfiguriert ist, um zu verhindern, dass das Anregungslicht, das von dem empfindlichen Bauteil oder von der Lichtquelle kommt, vom Lichtsensor empfangen wird, und eine Mehrkanal-Glasfaser (60) aufweist, von der ein erstes Ende mit einer Fläche des empfindlichen Bauteils verbunden ist und ein zweites Ende mit einem Modul (70) verbunden ist, das den Lichtdetektor und die Anregungslichtquelle aufweist.

9. Verfahren zur Messung eines elektromagnetischen Feldes mittels eines empfindlichen Bauteils (10), das ein erstes absorbierendes Material (11) und ein zweites fluoreszierendes und wärmeempfindliches Material (12) aufweist, wobei das zweite Material mehrere fluoreszierende Verbindungen umfasst, von denen jede geeignet ist, Fluoreszenzlicht mit unterschiedlicher Wellenlänge zu reemittieren, wobei das Verfahren **dadurch gekennzeichnet ist, dass** es die folgenden Schritte aufweist:

- Belichten (610) des empfindlichen Bauteils, das dem elektromagnetischen Feld ausgesetzt wird, mit einem vorbestimmten Anregungslicht,
- Erfassen (620) des Fluoreszenzlichts, das von dem zweiten Material beim Belichten des empfindlichen Bauteils mit dem vorbestimmten Anregungslicht reemittiert wird,
- Messen (630) des elektromagnetischen Feldes in Abhängigkeit von einer Intensität des erfassten Fluoreszenzlichts.

10. Verfahren zur Herstellung eines Bauteils, das gegenüber einem elektromagnetischen Feld empfindlich ist, **dadurch gekennzeichnet, dass** es einen Schritt aufweist zur Bildung von:

- einem ersten absorbierenden Material, das geeignet ist, Energie aus dem elektromagnetischen Feld zu absorbieren und die absorbierte Energie in Wärme umzuwandeln, und
- einem zweiten fluoreszierenden und wärmeempfindlichen Material, das mit dem ersten Material derart in Kontakt angeordnet wird, um die Wärme zu speichern, die von dem ersten Material umgewandelt wird, wobei das zweite Material geeignet ist, unter Einwirkung eines vorbestimmten Anregungslichts ein fluoreszierendes Licht mit einer Lichtstärke, die von der gespeicherten Wärme abhängig ist, zu reemittieren, wobei das zweite Material mehrere fluoreszierende Verbindungen umfasst, von denen jede geeignet ist, Fluoreszenzlicht mit unterschiedlicher Wellenlänge zu reemittieren.

11. Verfahren nach Anspruch 10, **dadurch gekennzeichnet, dass** der Schritt des Bildens darin besteht, eine verdampfbare Lösung aufzutragen, in der das erste und das zweite Material derart homogen vermischt werden, um eine Schicht aus einer homogenen Mischung des ersten und des zweiten Materials zu bilden.

12. Verfahren nach Anspruch 10, **dadurch gekennzeichnet, dass** der Schritt des Bildens darin besteht, nacheinander eine erste verdampfbare Lösung, die das erste Material umfasst, und eine zweite verdampfbare Lösung, die das zweite Material umfasst, auf die aufgetragene erste Lösung aufzutragen, derart, um eine Struktur aus übereinanderliegenden Schichten des ersten und des zweiten Materials zu bilden.

13. Verfahren nach Anspruch 10, **dadurch gekennzeichnet, dass** der Schritt des Bildens darin besteht, eine Abscheidelösung aufzutragen, in der das erste und das zweite Material homogen vermischt werden, derart, um eine Schicht aus einer homogenen Mischung des ersten und des zweiten Materials zu bilden.

14. Verfahren nach Anspruch 13, **dadurch gekennzeichnet, dass** der Schritt des Bildens darin besteht, nacheinander eine erste Schicht des ersten Materials und eine zweite Schicht des zweiten Materials auf die erste Schicht aufzutragen, derart, um eine Struktur aus übereinanderliegenden Schichten des ersten und des zweiten Materials zu bilden.

15. Computerprogrammprodukt, das Programmcodeanweisungen für das Umsetzen des Verfahrens nach Anspruch 9 aufweist, wenn das Programm auf einem Computer ausgeführt wird.

**Claims**

1. Component (10) sensitive to an electromagnetic field, comprising:

- a first absorbent material (11), able of absorbing energy of a given electromagnetic field and of converting the absorbed energy into heat;
- a second fluorescent and thermosensitive material (12) placed in contact with said first material in order to store the heat converted by said first material, said second material being able of re-emitting, under the action of a predetermined excitation light, a light by fluorescence of light intensity dependent on the stored heat,

said component being **characterised in that** said second material comprises a plurality of fluorescent compounds, each able to re-emit a light by fluorescence of a different wavelength.

2. Component according to claim 1, **characterized in that** it takes the form of a superposed coating structure comprising a first coating of said first material (11) and a second coating of said second material (12) applied on said first coating.

3. Component according to claim 1, **characterized in that** it takes the form of a coating in which said first and second materials (11; 12) are homogeneously mixed.

4. Component according to any of claims 1 to 3, **characterised in that** said first material (11) is a composite material comprising an electrically insulating matrix or electrically conductive particles.

5. Component according to claim 2, **characterised in that** the first coating is configured in the form of a periodic array of pads of said first material (11), said first material being a magnetic material.

6. Component according to any of claims 1 to 8, **characterised in that** the predetermined excitation light and the light by fluorescence re-emitted by said second material (12) have a different wavelength.

7. Device (100) for measuring an electromagnetic field **characterised in that** it comprises a sensitive component as defined according to any of claims 1 to 6, and **in that** it also comprises:

- a light source (20) configured to emit said predetermined excitation light;
- a light detector (30) configured to receive, from said sensitive component, light by fluorescence, and to detect the light intensity by received fluorescence.

8. Device according to claim 7, **characterised in that** it comprises a spectral filter (50) configured to prevent the excitation light from the sensitive component or from the light source, from being received by the light sensor, a multichannel optical fibre (60), the first end of which is connected to a face of the sensitive component, and the second end is connected to a module (70) comprising said light detector and said excitation light source.

9. Method for measuring an electromagnetic field by a sensitive component (10) comprising a first absorbent material (11) and a second fluorescent and thermosensitive material (12), said second material comprising a plurality of fluorescent compounds, each able to re-emit light by fluorescence with a different wavelength, said method being **characterised in that** it comprises the following steps:

- expose (610) said sensitive component, subjected to the electromagnetic field, to a predetermined excitation light;
- detect (620) the light by fluorescence re-emitted by said second material during the exposure of said sensitive component to the predetermined excitation light;
- measure (630) the electromagnetic field according to an intensity of the light by fluorescence detected.

10. Method of manufacturing a component sensitive to an electromagnetic field, **characterised in that** it comprises a step for the formation of:

- a first absorbent material, able of absorbing the energy of the electromagnetic field and of converting the energy absorbed into heat; and
- a second fluorescent and thermosensitive material, placed in contact with said first material in order to store the heat converted by said first material, said second material being able of re-emitting, under the action of a predetermined excitation light, a light by fluorescence with light intensity dependent on the stored heat, said second material comprising a plurality of fluorescent compounds, each able to re-emit the light by fluorescence with a different wavelength.

11. Method according to claim 10, **characterised in that** the formation step consists of applying a sprayable solution in which said first and second materials are homogeneously mixed, to form a coating of a homogeneous mixture of said first and second materials.

12. Method according to claim 10, **characterised in that** the formation step consists of successively applying a first sprayable solution comprising said first material and a second sprayable solution comprising said second material on the first solution applied, to form a structure of superposed coatings of said first and second materials.

13. Method according to claim 10, **characterised in that** the formation step consists of applying a deposition solution in which said first and second materials are mixed, to form a coating of a homogeneous mixture of said first and second materials.

14. Method according to claim 13, **characterised in that** the formation step consists of successively applying a first coating of said first material and a second coating of said second material on said first coating, to form a structure of superposed coatings of said first and second materials.

15. Computer program product comprising program code instructions for the implementation of the method according to claim 9 when said program is executed on a computer.

**Figure 1**

**Figure 2**

**Figure 3**

**Figure 4**

200

10    60    71    70    40

71

O

λ2    λ1

72

# Figure 5

600

Soumettre le composant sensible
au champ électromagnétique à mesurer

610

Activer la lumière d'excitation

620

Détecter la lumière fluorescente réémise

630

Mesurer le champ électromagnétique en fonction de
l'intensité de la lumière fluorescente détectée

# Figure 6

**Figure 7**

**EP 3 688 475 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2787583

- US 5658673 A